# EUROPÄISCHE PATENTSCHRIFT

(11) **EP 0 280 914 B1**
(45) Veröffentlichungstag und Bekanntmachung des Hinweises auf die Patenterteilung: **29.11.1995**
(21) Anmeldenummer: 88101665.3
(22) Anmeldetag: 05.02.1988
(51) Int. Cl.: H03M 13/00

(54) **Gerät zum Empfang von Daten**
Apparatus for data reception
Appareil pour la réception de données

(30) Priorität: 06.03.1987 DE 3707143
(43) Veröffentlichungstag der Anmeldung: 07.09.1988
(73) Patentinhaber: Blaupunkt-Werke GmbH, 31132 Hildesheim (DE)
(72) Erfinder: Hegeler, Wilhelm, D-3200 Hildesheim (DE)

(56) Entgegenhaltungen:
- US-A- 4 623 999

## Beschreibung

Die Erfindung betrifft einen RDS-Empfänger in dem aus einem empfangenen Datenwort und einer im Empfänger gespeicherten Paritätsprüfmatrix ein Syndrom gebildet wird, welches zur Fehlerfeststellung und gegebenenfalls Fehlerkorrektur angewendet wird.

Der Empfang von Daten, die mit Radiowellen übertragen werden, kann in vielfältiger Weise gestört sein. Es sind daher Verfahren zur Feststellung und/oder Korrektur von übertragungsfehlern bekannt geworden. Bei dem sogenannten Radiodatensystem (RDS) wird ein Hilfsträger mit digital-codierten Signalen moduliert, und zwar werden die Daten in Gruppen von jeweils vier Datenworten übertragen, wobei jeweils ein Datenwort aus einem Informationswort von 16 Bits und einem Prüfwort von 10 Bits besteht. Das Prüfwort wird bei dem Radiodatensystem nach einem vorgegebenen Algorithmus aus dem Informationswort gebildet, wobei dem eigentlichen Prüfwort noch ein sogenanntes Offset-Wort überlagert wird, das zur Synchronisierung dient.

Beim Empfang wird nach der Demodulation mit Hilfe des Prüfwortes eine Fehlerprüfung sowie eine Fehlerkorrektur vorgenommen. Eine ausführliche Beschreibung des Radiodatensystems RDS liegt in der Druckschrift vor: "Specifications of the Radio Data System RDS for VHF/FM Sound Broadcasting", Tech. 3244 - E, März 1984, herausgegeben von der European Broadcasting Union (EBU). Dabei erfordert die Syndrombildung einen erheblichen Rechenaufwand.

Aufgabe der Erfindung ist es daher, einen RDS-Empfänger zum Empfang von Daten, die mittels Radiowellen übertragen werden, anzugeben, bei welchem eine möglichst einfache Syndrombildung erfolgt.

Der erfindungsgemäße RDS-Empfänger mit den kennzeichnenden Merkmalen des unabhängigen Anspruchs hat den Vorteil, daß der Rechenaufwand bei der Syndrombildung verringert wird.

Für das erfindungsgemäße Gerät sind grundsätzlich auch festverdrahtete Schaltungen geeignet, obwohl das erfindungsgemäße Gerät mit Mikroprozessoren in vorteilhafter Weise ausgebildet werden kann. Dabei können die weiteren benötigten Komponenten, wie beispielsweise Speicher, an die Erfordernisse des erfindungsgemäßen Gerätes angepaßt sein. Je nach jeweils gewählter Ausführung wirken sich weitere Weiterbildungen des erfindungsgemäßen Gerätes im Sinne einer Verringerung des Schaltungsaufwandes direkt oder im Sinne einer Verringerung der Rechenzeit aus, was letztlich auch zu einer Reduzierung des Aufwandes oder zu einer Erhöhung der Korrekturkapazität führt.

Durch die in den abhängigen Ansprüchen aufgeführten Maßnahmen sind vorteilhafte Weiterbildungen und Verbesserungen der im unabhängigen Anspruch angegebenen Erfindung möglich.

Ausführungsbeispiele der Erfindung sind in der Zeichnung an Hand mehrerer Figuren dargestellt und in der nachfolgenden Beschreibung näher erläutert. Es zeigt:
- Fig. 1: eine schematische Darstellung der Syndrombildung mit Hilfe einer Paritätsprüfmatrix,
- Fig. 2: ein Blockschaltbild eines ersten Ausführungsbeispiels und
- Fig. 3: ein Blockschaltbild eines zweiten Ausführungsbeispiels.

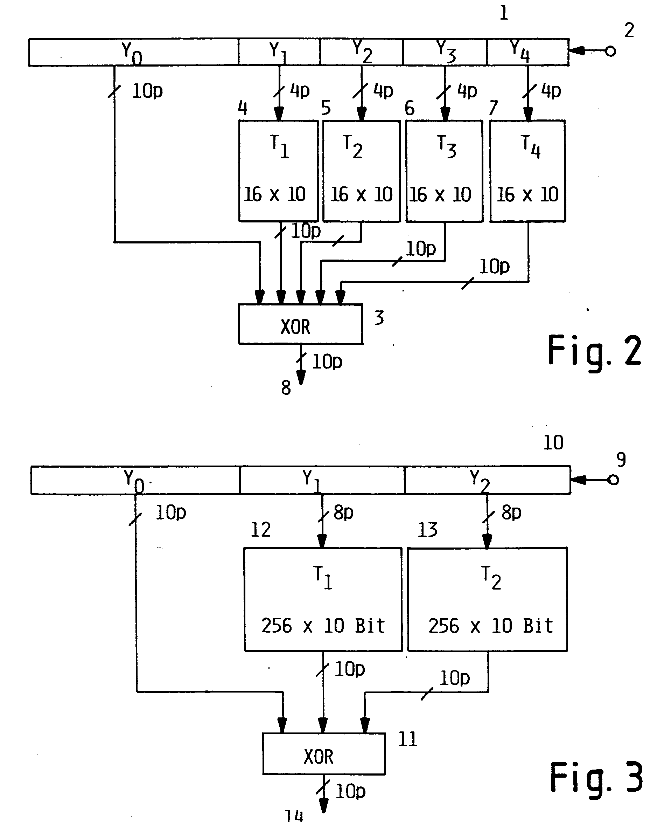

Zur Unterscheidung von den Bezugszeichen sind in den Figuren 2 und 3 die Zahlen, welche die Anzahl der jeweils parallelen Bits angeben, mit einem p versehen.

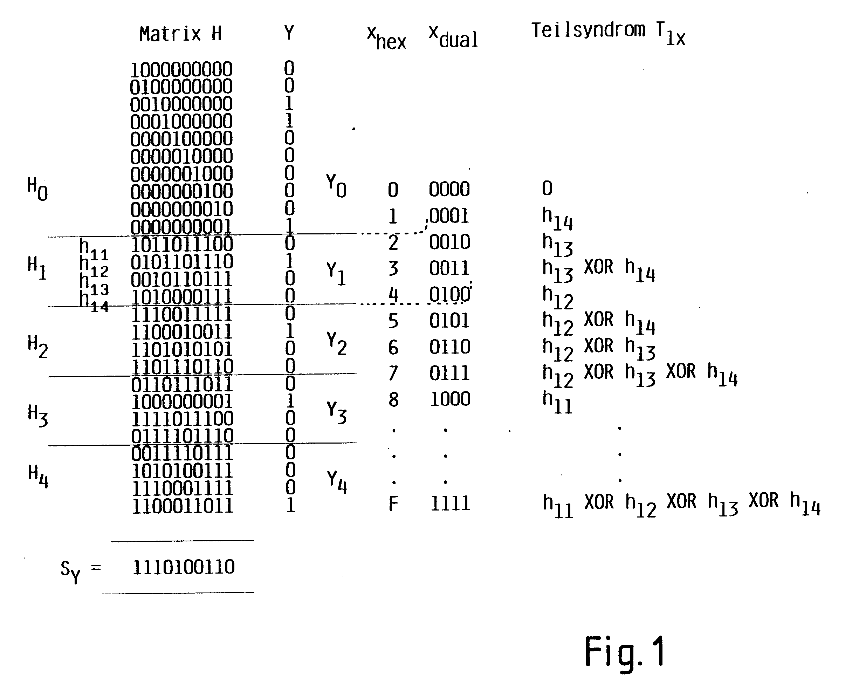

Zur Erläuterung der Syndrombildung ist in Fig. 1 die in der obengenannten EBU-Veröffentlichung vorgeschlagene Paritätsprüfmatrix H sowie ein Beispiel eines Datenwortes Y und des aus diesem Datenwort und der Matrix H gebildeten Syndroms S_{Y} dargestellt. Die Matrix H besteht aus 26 Zeilen mit jeweils 10 Spalten. Nach den bekannten Verfahren erfolgt die Berechnung des Syndroms S_{Y} für das Datenwort Y nun derart, daß alle Zeilen der Matrix H miteinander exklusiv-oder-verknüpft werden, bei welchen das Datenwort den Wert 1 aufweist. Durch die mehrfache Exklusiv-Oder-Verknüpfung ergibt sich bekanntlich bei Vorliegen einer ungeraden Anzahl von Einsen eine 1 und bei einer geraden Anzahl von Einsen eine 0.

Sind viele Einsen im Datenwort Y vorhanden, werden zur Berechnung eines einzigen Syndroms bereits viele Exklusiv-Oder-Verknüpfungen benötigt. Je nach Systemparametern und geforderter Qualität der Fehlerfeststellung und -korrektur im einzelnen können viele Syndromberechnungen in einer vorgegebenen Zeit erforderlich sein.

Zur erfindungsgemäßen Syndrombildung wird das Datenwort Y in mehrere Gruppen Y₀ bis Y₄ eingeteilt. Eine entsprechende Einteilung wird ebenfalls bei der Matrix H vorgenommen. Aus jeweils einer der Gruppen Y₁ bis Y₄ ist mit der dazugehörigen Teilmatrix ein Teilsyndrom T₁ bis T₄ gebildet und für alle vorkommenden Werte von Y₁ bis Y₄ in Speichern abgelegt.

Die Bildung der Teilsyndrome ist in Fig. 1 an Hand des Teilsyndroms T₁ₓ erläutert. Dazu sind die vorkommenden Werte von Y₁ sowohl als Hexadezimalzahl als auch als Dualzahl aufgeführt und dazu die jeweils zuverknüpfenden Zeilen h₁₁ bis h₁₄ der Matrix H₁ an gegeben. Der Übersichtlichkeit halber sind die Zeilen für die Werte 9 bis E nicht dargestellt.

Die Bildung eines Teilsyndroms aus der Gruppe Y₀ erfordert keine weiteren Schritte, da wegen der Eigenschaft der Teilmatrix H₀ das Teilsyndrom T₀ gleich der Gruppe Y₀ ist.

Jeweils ein Datenwort Y wird bei der Anordnung nach Fig. 2 in einem Speicher 1 - beispielsweise einem Schieberegister - zwischengespeichert. Dazu werden die Bits des Datenwortes Y seriell über einen Eingang 2 eingelesen und können parallel 26 verschiedenen Ausgängen entnommen werden. Dabei sind Ausgänge für die ersten zehn Bits (Y₀) des Datenwortes Y direkt mit Eingängen einer zehnfach parallelen Exklusiv-Oder-Schaltung 3 verbunden. Die anderen Ausgänge des Speichers 1 sind in vier Gruppen zu jeweils vier Bit zusammengefaßt und an Adresseneingänge weiterer Speicher 4 bis 7 (im folgenden Tabellenspeicher genannt) angeschlossen. Jeder der vier Tabellenspeicher enthält 16 10-Bit-Worte als Teilsyndrome. Je nach zugeführter Adresse x wird eines der 16 Teilsyndrome ausgelesen und einem der Eingänge der Exklusiv-Oder-Schaltung 3 zugeführt. Am Ausgang 8 der Exklusiv-Oder-Schaltung 3 steht dann das Syndrom S_{Y} zur Verfügung. Im Gegensatz zu der bekannten Bildung des Syndroms ist bei der Anordnung nach Fig. 2 lediglich eine Exklusiv-Oder-Verknüpfung von fünf Teilsyndromen erforderlich - d. h. bei einer seriellen Abarbeitung der Exklusiv-Oder-Verknüpfungen werden nur vier Rechenschritte benötigt.

Fig. 3 zeigt ein anderes erfindungsgemäßes Gerät, bei welchem das Datenwort Y ebenfalls über einen Eingang 2 in einen Speicher 1 eingelesen wird und eine erste Gruppe Y₀ von zehn Bit direkt den entsprechenden Eingängen einer Exklusiv-Oder-Schaltung 11 zugeführt ist. Der weitere Teil des Datenwortes Y ist in zwei Gruppen Y₁ und Y₂ von jeweils acht Bit aufgeteilt. Die Speicher 12, 13 haben in entsprechender Weise acht Bit breite Adressen und beinhalten jeweils 256 Teilsyndrome mit jeweils zehn Bit. Bei der anschließenden Exklusiv-Oder-Verknüpfung 11 ist dann lediglich die Verknüpfung von drei Teilsyndromen mit jeweils zehn Bit erforderlich. Am Ausgang 14 steht dann das Syndrom S_{Y} zur Verfügung.

Gegenüber der Anordnung nach Fig. 2 wird bei der Anordnung nach Fig. 3 mehr Speicherplatz benötigt. Diesem steht jedoch eine kürzere Rechenzeit gegenüber. Bei 8-Bit-Mikroprozessoren ist eine Unterteilung von Y in 8-Bit-Gruppen ohnehin vorhanden, so daß die eigentliche Syndromberechnung dann auf zwei Exklusiv-Oder-Ableitungen reduziert ist.

## Patentansprüche

1. RDS-Empfänger in dem aus einem empfangenen Datenwort und einer im Empfänger gespeicherten Paritätsprüfmatrix ein Syndrom gebildet wird, welches zur Fehlerfeststellung und gegebenenfalls Fehlerkorrektur angewendet wird,
dadurch gekennzeichnet,
daß weitere Speicher für Teilsyndrome vorgesehen sind, deren Adressen aus mehreren Gruppen von Bits des Datenworts bestehen, wobei jedoch diejenigen Bits des Datenworts, bei welchen die zugeordneten Zeilen der Paritätsprüfmatrix nur eine 1 aufweisen, bei der Adressenbildung unberücksichtigt bleiben, daß die unter diesen Adressen gespeicherten Teilsyndrome aus den jeweiligen Zeilen der Paritätsprüfmatrix durch exklusiv-oder Verknüpfung gebildet sind, welche den Bits der die Adresse bildenden Gruppe zugeordnet sind und den Wert 1 aufweisen, und daß die Teilsyndrome untereinander und mit den bei der Adressenbildung unberücksichtigten Zeilen der Paritätsprüfmatrix exklusiv-oder verknüpft werden.

2. RDS-Empfänger nach Anspruch 1,
dadurch gekennzeichnet,
daß ein 26-Bit-Datenwort in eine Gruppe von 10 Bits, welche mit den Teilsyndromen exklusiv-oder verknüpft wird und in vier Gruppen mit jeweils 4 Bits aufgeteilt wird.

3. RDS-Empfänger nach Anspruch 1,
dadurch gekennzeichnet,
daß ein 26-Bit-Datenwort in eine Gruppe von 10 Bit, welche mit den Teilsyndromen exklusiv-oder verknüpft wird und in zwei Gruppen mit jeweils 8 Bit aufgeteilt wird.

## Claims

1. RDS receiver in which a syndrome used for error determination and, if appropriate, error correction is formed from a received data word and a parity checking matrix stored in the receiver, characterized in that further memories are provided for subsyndromes, the addresses of which comprise a plurality of groups of bits of the data word, those bits of the data word for which the assigned rows of the parity checking matrix have only a 1 being ignored, however, during address formation, in that the subsyndromes stored under these addresses are formed by an exclusive-OR operation from the respective rows of the parity checking matrix which are assigned to the bits of the group forming the address and have the value 1, and in that the subsyndromes are combined by an exclusive-OR operation with one another and with the rows of the parity checking matrix ignored during the address formation.

2. RDS receiver according to Claim 1,characterized in that a 26-bit data word is divided into one group of 10 bits which is combined with the subsyndromes by an exclusive-OR operation and into four groups each having 4 bits.

3. RDS receiver according to Claim 1, characterized in that a 26-bit data word is divided into one group of 10 bits which is combined with the subsyndromes by an exclusive-OR operation and into two groups each having 8 bits.

## Revendications

1. Récepteur RDS dans lequel on forme un syndrome à partir d'un mot de données reçu et d'une matrice de contrôle des parités, enregistrée dans le récepteur, syndrome utilisé pour détecter les erreurs et le cas échéant les corriger, caractérisé, par d'autres mémoires pour des sous-syndromes, dont les adresses se composent de plusieurs groupes de bits du mot de données, et les bits du mot de données dont les lignes associées dans la matrice de contrôle de parités ne comportent que 1, ne sont pas prises en compte pour former l'adresse, et les sous-syndromes enregistrés sous ces adresses, sont formés à partir des lignes respectives de la matrice de contrôle de parités par une combinaison OU-exclusif, associée aux bits du groupe formant l'adresse, et qui ont la valeur 1 et en ce que l'on combine les sous-syndromes entre eux et avec les lignes non prises en compte dans la formation des adresses dans la matrice de contrôle de parités par une combinaison OU-exclusif.

2. Récepteur RDS selon la revendication 1, caractérisé en ce qu'on répartit un mot de données de 26 bits en un groupe de 10 bits combinés par une porte OU-exclusif aux sous-syndromes et en quatre groupes de chaque fois 4 bits.

3. Récepteur RDS selon la revendication 1, caractérisé en ce qu'un mot de données de 26 bits se combine en un groupe de 10 bits, selon la fonction logique OU-exclusif avec des sous-syndromes et se répartit en deux groupes de chaque fois 8 bits.
